# EUROPEAN PATENT SPECIFICATION

(11) **EP 1 302 776 B1**
(45) Date of publication and mention of the grant of the patent: **25.08.2004**
(21) Application number: 01402617.3
(22) Date of filing: 10.10.2001
(51) Int. Cl.: G01R 31/3185

(54) **Automatic scan-based testing of complex integrated circuits**
Automatische Abtastprüfung von komplexen integrierten Schaltungen
Essai automatique par balayage de circuits intégrés complexes

(43) Date of publication of application: 16.04.2003
(73) Proprietor: MOTOROLA, INC., Schaumburg, IL 60196 (US)
(72) Inventor: Bailliet, Benoit Antoine, Toulouse 31000 (FR); Lecain, Didier, Toulouse 31400 (FR)
(74) Representative: Wharmby, Martin Angus

(56) References cited:
- US-A- 6 115 827

## Description

### Field of the invention

This invention relates generally to testing integrated circuits and more particularly to automatic scan-based testing of the functionality of complex integrated circuits.

### Background of the invention

Complex integrated circuits often contain one or more embedded core data processors that communicate with peripherals, memory, or other circuitry on the same substrate. A method of automatic scan-based testing of such integrated circuits is described in US Patent N° 5 717 700, assigned to the present Applicant.

The complexity of modern integrated circuits ('chips') continues to increase at a dramatic rate. Modern integrated circuits include millions of transistors contained on a single substrate. In order to create the millions of transistors on the substrate, the size of each transistor has decreased dramatically. Thus, today, a single integrated circuit takes up less area, operates more quickly, and consumes less power than ever before. However, with the increase in transistor numbers on each integrated circuit, the likelihood that at least one transistor contained on the integrated circuit malfunctions after fabrication also increases and its testing becomes more and more complex. Thus, automated testing methods are used to verify the operation of integrated circuits after fabrication but prior to sale.

For example, if there are 3 million transistors on an integrated circuit packed in a 300 pin package, an average of (3,000,000/300)=10,000 transistors must be tested by each pin in a best case. Further, many techniques that have been used to test and verify densely packed circuit board designs cannot be used within the operation of the integrated circuit because there is no direct access to many of the circuits within the packaged and sealed integrated circuit.

The 'scan'-based test technique described in US Patent N° 5717 700 is a cost-effective solution to test the operation of integrated circuits, which include functional logic elements and register elements, such as flip-flop circuits or latches, with functional interconnections between the different elements. The integrated circuit design includes specific provision for re-configuring the interconnections of the elements of the integrated circuit so that test data signals entered serially at one or more input pins can be shifted ('scanned') along a scan chain different from the normal functional system path from one register element to another in order to place the signals of the test vector at the desired positions. The integrated circuit returns then temporarily to its normal functional system configuration for one or more clock pulses to produce test outputs corresponding to a particular logic function outcome from the normal logic functions in the integrated circuit, given the values of the test vector. The integrated circuit then reverts to the scan configuration and shifts out the test outputs along the scan chain to one or more output pins where they can be retrieved and compared with the expected results to diagnose faults.

This scan-based test method has to be provided for during design of the integrated circuit ('Design-for-Test'). Additional scan interconnection routes for the scan chain are included linking alternative scan inputs and outputs for scan data parallel to the functional data inputs and outputs, and which are added to certain of the basic elements (flip-flops and latches) within the integrated circuits. The alternative input for scan data of a scan element may be implemented by placing a multiplexor in front of the standard input of the scan element to select either scan data or functional data. These 'scan configurable' elements are then connected together in a serial shift register fashion during the scan configuration by connecting the scan output of one element to the scan input of the next element of the scan chain in response to a scan_enable signal asserted on an 'enable' input of the scan configurable elements. The scan chain can then load scan test data (and simultaneously unload the test results that give internal integrated circuit state information) by allowing scan data to be transferred from one element to another on each active scan clock edge. After loading the scan test data to place the elements of the scan chain in a desired state for the test, the scan_enable signal is de-asserted (set to 'zero' if its asserted value is 'one') temporarily to use the functional data input of the scan elements to capture data from the logic circuit elements in functional mode for one or more clock cycles. The scan_enable signal is then re-asserted and the test results unloaded (and fresh scan test data for the next phase of the test simultaneously loaded).

By selectively loading scan data and varying scan clocking frequencies, the technique of providing scan data in scan mode and switching to functional mode for more than one clock cycles may be employed to verify time delays of portions of the logic circuitry in the integrated circuit.

Thus, the scan design has the effect of turning each selected sequential scan configurable device (flip-flop or latch) into an internal test point. In a typical scan-configurable device, as for a flip-flop, the standard input is referred to as the D-input while the standard output is referred to as the Q-output, the scan test data input and output being referred to as SD-input and SD-output respectively. Thus, the D-input of each scan configurable device is a settable test point and the Q-output a primary output test point while the SD-input and SD-output are data loading and unloading points in the scan chain.

It will be appreciated that not every storage element need be converted to a scan element to provide benefits through scanning. If all elements are convened, then the design architecture is known as full-scan. However, if only selected storage elements are convened, then the design architecture is known as partial-scan. If both full-scan or partial-scan are supported, the economics of testing improve. Scan architecture of either type allows each scanned sequential device to be viewed as if it were a package pin that reduces the gate/transistor-to-pin ratio (for example 3 million transistors in a 300 pin package with 10,000 scan configurable sequential elements has a figure of merit of 291 transistors per pin). Since the logic functions are more accessible, an integrated circuit incorporating scan architecture requires fewer test vectors and less test time. A reduction in testing time results in a reduction in per device cost of manufacturing the integrated circuit

Also, a single chip may be designed using several modules that had previously been designed for different chips and brought together in a new configuration. Partial-scan enables the test patterns developed for those modules also to be re-used in the new chip design. Partial-scan also offers an improvement in the availability of pins for introducing external scan test signals and more flexibility in the choice of different test techniques for different modules, for example.

A potential problem for partial-scan is that the data input signals at certain points, especially at the interfaces (or 'gaskets') of the modules, for example, may not be controlled, that is to say the signal propagated may be 'unknown' (unpredictable). Even if the data input signals are controlled in the chip for which the module is first designed, it is desirable to provide for re-use of the module with a minimum of re-design of its architecture and software in future different chips. Accordingly, it is desirable to provide for selective control of at least certain scan test data input signals.

Testing of substantially the whole chip may be obtained by dividing the complete chip into different scan domains, each incorporating several parallel scan chains, and whose boundaries may coincide in certain cases with the boundaries of the different modules; however, one module might include more than one domain or, more typically, one domain may include more than one module. The domains are separated during the scan configuration in response to a scan_mode signal. The scan data of the different domains are then entered and the tests of the different domains applied sequentially. Such a system and method is referred to herein as a 'domain scanning' test system and method.

A boundary scan system for circuit boards is described in US Patents N° 5 450 415 and N° 6 115 827 it is possible to adapt such a boundary scan system for integrated circuits by adding flip-flop and multiplex elements, referred to as scan wrappers, to input end elements of the scan chains in the integrated circuits to define the values of the scan test data signals at each point where the signal would otherwise be unknown. However, this configuration creates substantial additional hardware (a large chip may include 7 scan domains and 30 or more modules each of which requires control of many unknown inputs at the interfaces), introduces an additional time lag in the system operational functions, is inflexible in terms of re-use of the modules in other future chips and the testing of the real functional path is sub-optimal.

### Summary of the invention

The present invention provides a method of testing an integrated circuit as described in the accompanying claims and an integrated circuit tested by a method as described in the accompanying claims

### Brief description of the drawings

Figure 1 is a schematic diagram of a simplified elementary module in a known type of full-scan-configurable integrated circuit,
Figure 2 is a generalised schematic diagram of a module in a known type of partial-scan-configurable integrated circuit, showing a domain boundary,
Figure 3 is a diagram showing signals appearing in domain scan operation of a partial-scan-configurable integrated circuit such as the integrated circuit of Figure 2,
Figure 4 is a schematic diagram of a module in a partial-scan-configurable integrated circuit in accordance with one embodiment of the present invention,
Figure 5 is a schematic diagram of a scan element in the partial-scan-configurable integrated circuit of Figure 4, and
Figure 6 is a schematic diagram of a module in a partial-scarrconfigurable integrated circuit in accordance with another embodiment of the present invention

### Detailed description of the preferred embodiments

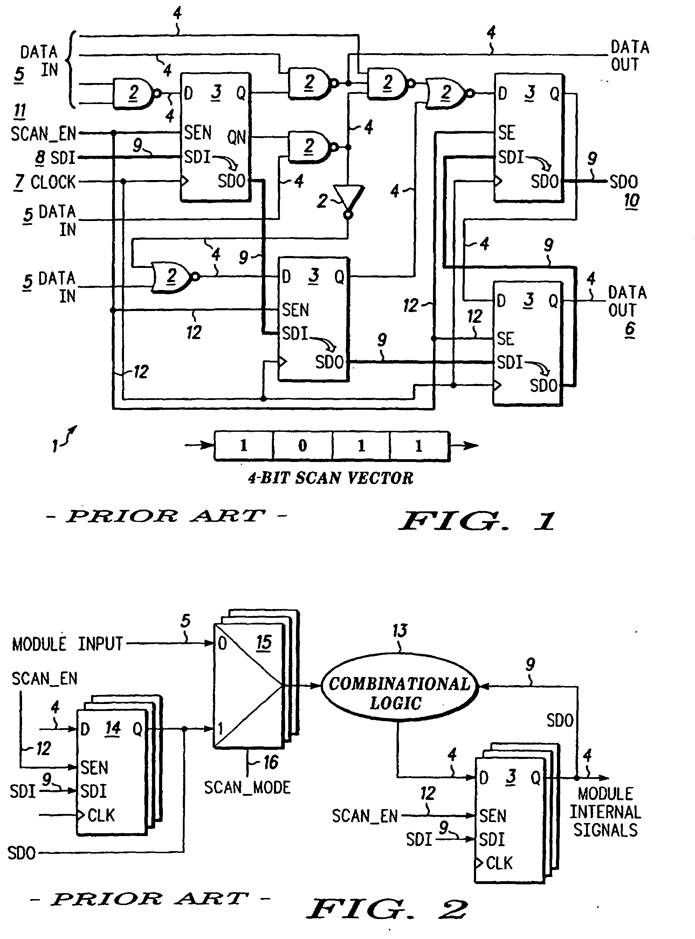

Figure 1 illustrates a simplified module 1 in an integrated circuit. The module comprises logic elements 2 including gates and inverters, for example, and register elements 3, the logic elements 2 and register elements 3 being normally interconnected in a functional configuration by electrically conductive connections 4 between data input points 5 and data output points 6. The module 1 also includes a clock signal input point 7 to which clock signals are applied and asserted on corresponding clock inputs of the register elements 3 to enable a change of state of the register elements.

The module 1 also includes a scan data input point 8 to which scan data signals are applied, the scan data input point 8 being the start of a scan chain comprising electrically conductive scan conductors 9 interconnecting the register elements 3 with the scan data input point 8, the scan data input SDI of the register elements 3 being connected to scan data outputs SDO of the previous register element 3 in the chain except for the first register element 3 in the chain, which is connected to the scan data input point 8 and the last register element 3 in the chain whose scan data output SDO is connected to a scan data output point 10. The module 1 also includes a scan enable input point 11, which is connected to scan enable conductors 12, connected to control inputs SEN of the register elements 3, the control input SEN switching the register elements from their normal data inputs D to the scan data inputs SDI when a scan_enable signal is asserted on the input 11.

In normal operation of the module 1, the logic elements 2 and the register elements 3 are connected by the conductors 4 between the data input point 5 and the data output point 6. The scan_enable signal applied to the scan enable input point 11 is not asserted so that the data inputs D of the register elements 3 are functional and not the scan data inputs SDI. The module then performs its normal functional operation in response to clock signals applied to the clock input point 7.

During scan test, the scan_enable signal applied to the scan enable input point 11 is asserted so that the scan data inputs SDI of the register elements 3 are operational instead of the functional data inputs D. Serial data applied to the scan data input 8 may then be shifted along the chain of register elements 3 in response to clock pulses applied to the clock input point 7 to load known data into the register elements 3 and set them to desired state. The scan_enable signal applied to the input point 11 is then de-asserted for one or more cycles of clock pulses so that the logic elements 2 and the register element 3 are interconnected again by the functional configuration of conductors 4 and the module 1 performs its logic function on data applied to the data input points 5 and the data loaded into the register elements 3. Lastly, the scan_enable signal applied to the input point 11 is asserted again and the new state of the register elements 3 consecutive to the functioning of the module 1 with the loaded data is shifted out along the conductors 9 and the chain of register elements 3 to the scan data output point 10 where it may be compared with expected values of the test results to check the proper functioning of the module 1.

The module 1 is shown with all of the register elements 3 connectible in the scan chain by scan conductors 9. However, it will be appreciated that in practice, especially with large modules, the architecture employed may be partial-scan in which only certain, selected ones of the register elements 3 are connected in the scan chain.

Figure 2 shows a previously proposed boundary scan system schematically. In the module illustrated in Figure 2, a register 3 is shown connected with the connector 4 supplying data, the conductor 12 supplying the scan_enable signal and a conductor 9 supplying the scan data input signal, the remainder of the logic elements being shown globally at 13. An additional register 14, such as a flip-flop circuit, is provided for a point whose inputs are treated as unknown and therefore to be controlled. The register 14 receives data inputs over the functional configuration conductors 4 within the module, scan data input signals over the scan chain conductors 9 and scan_enable signals over the conductors 12. The output of the register 14 is connected to the input of a multiplexor 15 that also receives a data input signal from the module data input point 5. A scan mode signal is applied to a control input 16 of the multiplexor 15 to select either the data input signal from the module data input point 5 in functional configuration or the output of the register 14 in scan and scan test configuration.

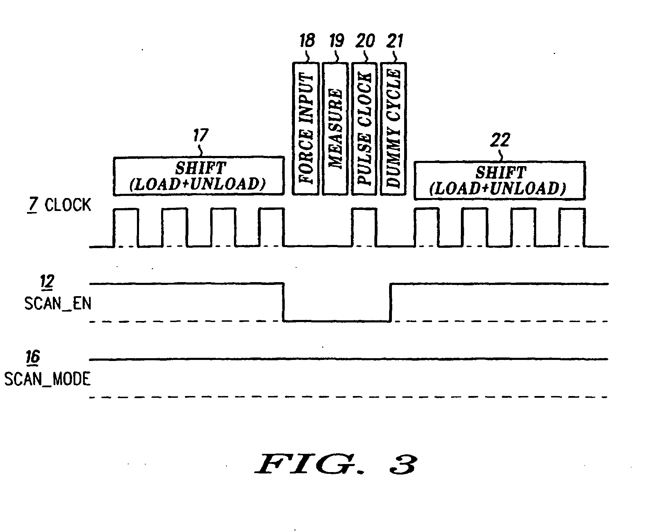

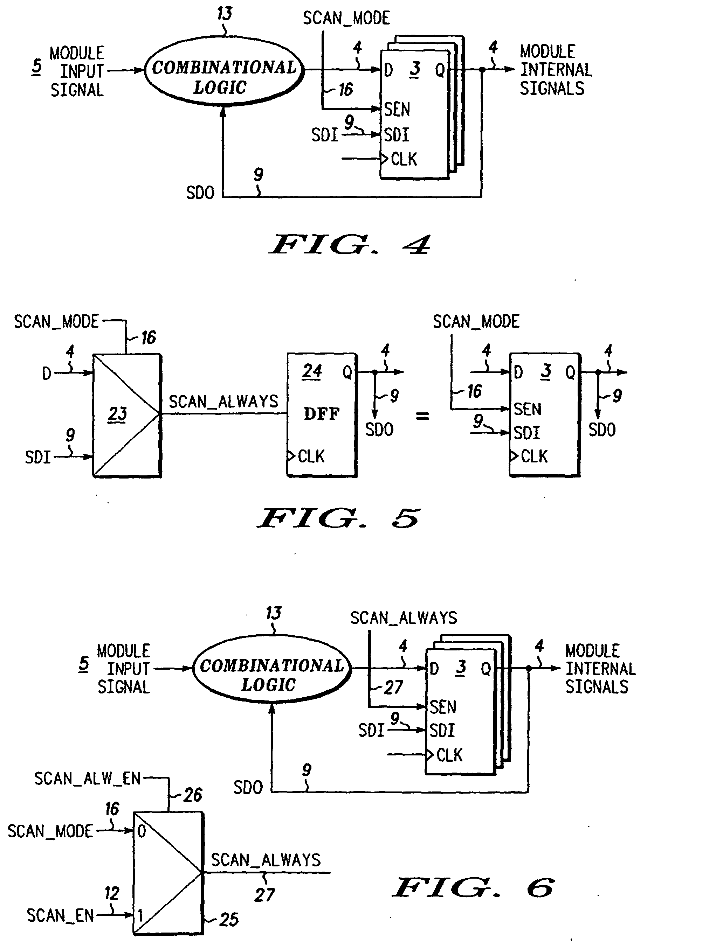

Referring now to Figure 3, the timing of the signals applied are seen together with the corresponding operations of the registers. For those modules that are to be scanned, the scan mode signal is asserted at 16 and initially the scan enable signal is asserted at 12 during a first shift phase 17, during which clock pulses are applied on the conductors 7. Simultaneously, the desired scan data inputs are applied serially on the scan data input point 8 and transmitted over the scan configuration conductors 9 through the register elements 3. When all the scan data input signals are in place on the different register elements 3, and including the register element 14 in the case of the module shown in Figure 2, the scan enable signal is de-asserted on the conductors 12, which has the effect of forcing the D inputs of the register elements 3 and 14. The corresponding values then appear at the outputs of the register elements 3 and 14 as shown at 19. One or more clock pulses are applied at the clock input point 7, as shown at 20, so that the logic elements 13, which are now in the functional configuration, process the data over the connectors 4 interconnection. The scan_enable signal is then reasserted on the scan enable input point 11 to reconnect the register elements 3 and 14 in the scan configuration by conductors 9 and, during a second shift phase 22, clock pulses are applied again to the clock input point 7 to shift the data from the outputs of the register elements 3 and 14 serially to the output point 10. It will be appreciated that, while the scan data is being loaded in the first phase 17, data from a previous test is simultaneously being unloaded from the same register elements and conversely during the second shift phase 22, as data is being unloaded, data for the next scan can be loaded for the next test.

While a single element comprising the register 14 and the multiplexor 15 is shown being controlled in Figure 2, it will be appreciated that in a typical module several points within the module will be controlled and for each one an additional register 14 and an additional multiplexor 15 are provided in this prior system as indicated by the repetition symbols for the elements 14 and 15. Moreover, the additional elements 14 and 15 are inserted in the data flow path of the functional configuration including conductor 4 and introduce additional time lags in the system's operational functions.

Figure 4 shows an embodiment of the present invention that avoids any need for an additional register such as 14 or an additional multiplexor such as 15. In this embodiment of the invention, the scan mode signal on conductor 16 is applied directly to the scan enable input SEN of each of the normal register elements forming part of the module operational circuitry instead of the scan_enable signal, for those elements where it is desired to control the data that the register transmits over the functional configuration conductors 4 during the data capture phases 18 to 21 of the scan test. In operation, during the whole of the scan test for this domain, the scan mode signal on conductor 16 is asserted so that the corresponding register elements 3 capture the scan data input signals on the conductors 9 and not the data signals from the logic elements supplied over the conductors 4.

Figure 5 shows the structure of those register elements 3 that are to have their inputs controlled in this manner. The register element 3 in this case is equivalent to a multiplexor sub-element 23 receiving as inputs the signals on the data conductor 4 from the logic element and the scan data signals on the conductor 9, the selection between the two inputs being made by the scan mode signal applied over conductor 16 to a control input of the multiplexor sub-element 23. The output of the multiplexor sub-element 23 is a "scan_always" signal that corresponds to the scan data signal during the whole of the scan test, including both the shift phases 17 and 22 and the test phases 18 to 21. The scan_always signal is applied to the data input of a simple digital flip flop 24 whose output gives the data signals on the conductor 4 and the scan data signals on the scan configuration conductors 9.

While the embodiment of the invention illustrated in Figures 4 and 5 offers substantial advantages compared to prior systems, the embodiment of the invention shown in Figure 6 offers a substantial improvement in flexibility of use at the cost of a small increase in hardware and additional input points.

In the embodiment of the invention shown in Figure 6, groups of the register elements 3 whose data inputs over the lines 4 it may or may not be desired to control during the scan test process are connected to an additional multiplexor element 25, as many multiplexor elements 25 being provided as there are separate groups of register elements 3 that it may be desired to control separately. Each multiplexor element 25 has an input connected to a scan enable conductor 12 and another input connected to a scan mode conductor 16. A control input of the multiplexor 25 is connected to a respective conductor 26 to which a "scan_always_enable" signal is applied from an input point. The output of the multiplexor elements 25 are applied over "scan_always" conductors 27 to the scan enable inputs SEN of their respective groups of register elements 3.

In operation, if it is desired to control the inputs used during the scan test for a particular group of register elements 3, the scan_always_enable signal is asserted on line 26 for that group and the corresponding multiplexor 25 selects the scan mode signal on conductor 16 instead of the scan_enable signal on conductor 12. The scan mode signal is then applied on the scan_always conductor 27 to that group of register elements 3 in place of a scan_enable signal, and the scan mode signal, asserted if this domain is to be scanned, is asserted on the scan enable inputs SEN of that group of register elements 3 during the whole of the scan operation. If, on the other hand, the group of register elements 3 is to behave in a normal scan function during the scan process, the scan_always_enable signal on conductor 26 is de-asserted during the scan operation so that the corresponding multiplexor 25 selects the scan_enable signal on the conductor 12. This signal then appears at the scan_always conductor 27 and is applied to the scan enable input SEN of the corresponding group of register element 3, as shown in Figure 3.

It will be appreciated that these embodiments of the invention interpose no extra hardware in the data flow path of the functional configuration, so that no time delays are introduced into this flow path. The propagation of unknown values during the test process is avoided, without substantial additional hardware, and the embodiment of Figure 6 offer a flexible solution that is particularly valuable where a module is to be used in future integrated circuits or otherwise is not always to be implemented in scan domain mode.

## Claims

1. A method of testing an integrated circuit comprising logic circuit elements (2, 13) and scan circuit elements (3), functional interconnections (4) for connecting said circuit elements (2, 3, 13) in a functional configuration for processing data input signals, at least one scan_data signal input (8), and scan interconnections (9) for selectively connecting said scan circuit elements (3) with said scan_data input (8) in a plurality of scan domains in respective scan configurations, the method comprising selectively applying a scan_mode signal to said scan circuit elements (3) to select one of said scan domains, interconnecting the scan circuit elements (3) of said selected scan domain in said scan configuration in response to a scan_enable signal asserted on scan_enable inputs (SEN) of the scan circuit elements (3) of at least the selected scan domain during a first scan phase (17), applying scan_data signals to said scan_data input (8) so that said scan_data signals are shifted sequentially through, and registered by, the interconnected scan circuit elements (3) of the corresponding domain in response to clock pulses applied at least to said scan circuit elements (3) during said first scan phase (17), interconnecting at least the circuit elements (2, 3, 13) of said selected scan domain in said functional configuration during a capture phase (18 to 21) in response to de-assertion of said scan_enable signal so that said functional configuration of said selected scan domain processes data input signals and the signals registered by said scan circuit elements (3) in response to clock pulses applied to said circuit elements during said capture phase (18 to 21), interconnecting the scan circuit elements (3) of said selected scan domain in said scan configuration again in response to re-assertion of said scan_enable signal during a second scan phase (22) so as to shift the output signals of said scan circuit elements (3) of said selected scan domain to at least one scan data signal output (10) in response to said clock pulses applied to said scan circuit elements (3) during said second scan phase (22), and comparing the actual output signals from said scan data signal output (10) with expected scan output signals,
**characterised in that** scan circuit elements (3) of a group within said selected scan domain are connected to other circuit elements according to said scan configuration in response to said scan_mode signal at least during said capture phase (18 to 21), whereby to process signals received from said scan configuration during said capture phase (18 to 21).

2. A method as claimed in claim 1, **characterised in that** said scan_mode signal is asserted on said scan_enable inputs (SEN) of the scan circuit elements (3) of said group at least during said capture phase.

3. A method as claimed in any preceding claim, wherein, for a plurality of said scan circuit elements (3), scan_select signals (scan_always_en) are asserted or not to select between said scan_enable signal and said scan_mode signal to produce selective_scan signals (scan_always), which are applied to said scan_enable inputs (SEN) of said plurality of scan circuit elements (3) at least during said capture phase (18 to 21), so as to select whether the scan circuit elements (3) of said plurality of scan circuit elements are included in said group and process signals received from said scan configuration, or are excluded from said group and process signals received from said functional configuration during said capture phase (18 to 21).

4. An integrated circuit comprising all the components set out in claim 1 and tested by a method as claimed in claim 2, wherein at least a plurality of said scan_enable inputs (SEN) of the scan circuit elements (3) of said group are connected to receive said scan_mode signal.

5. An integrated circuit comprising all the components set out in claim 1 and tested by a method as claimed in claim 3, comprising a plurality of selection circuit elements (25) having scan_select inputs on which scan_select signals (scan_always_en) may be asserted to select between said scan_enable signal and said scan_mode signal to produce said selective_scan signals (scan_always), said selection circuit elements (25) being connected to apply the selected signal to more than one of said scan circuit elements.

## Patentansprüche

1. Verfahren zum Prüfen einer integrierten Schaltung, die Folgendes umfasst: Logikschaltungselemente (2, 13) und Abtastschaltungselemente (3), funktionale Verbindungen (4) zum Verbinden der Schaltungselemente (2, 3, 13) in einer funktionalen Konfiguration zum Verarbeiten von Dateneingangssignalen, mindestens einen Abtastdatensignaleingang (8) und Abtastverbindungen (9) zum selektiven Verbinden der Abtastschaltungselemente (3) mit dem Abtastdateneingang (8) in einer Mehrzahl von Abtastdomänen in den jeweiligen Abtastkonfigurationen, wobei das Verfahren Folgendes umfasst: selektives Zuführen eines Abtastmodussignals zu den Abtastschaltungselementen (3), um eine der Abtastdomänen auszuwählen, Verbinden der Abtastschaltungselemente (3) der ausgewählten Abtastdomäne in der Abtastkonfiguration in Reaktion auf ein Abtastfreigabesignal, das an Abtastfreigabeeingängen (SEN) der Abtastschaltungselemente (3) mindestens der ausgewählten Abtastdomäne während einer ersten Abtastphase (17) anliegt, Zuführen von Abtastdatensignalen zu dem Abtastdateneingang (8), so dass die Abtastdatensignale sequentiell durch die verbundenen Abtastschaltungselemente (3) der entsprechenden Domäne in Reaktion auf Taktimpulse, die mindestens den Abtastschaltungselementen (3) während der ersten Abtastphase (17) zugeführt werden, verschoben und durch sie registriert werden, Verbinden mindestens der Schaltungselemente (2, 3, 13) der ausgewählten Abtastdomäne in der funktionalen Konfiguration während einer Erfassungsphase (18 bis 21) in Reaktion auf ein Nichtanliegen des Abtastfreigabesignals, so dass die funktionale Konfiguration der ausgewählten Abtastdomäne die Dateneingangssignale und die durch die Abtastschaltungselemente (3) registrierten Signale in Reaktion auf Taktimpulse, die den Schaltungselementen während der Erfassungsphase (18 bis 21) zugeführt werden, verarbeitet, erneutes Verbinden der Abtastschaltungselemente (3) der ausgewählten Abtastdomäne in der Abtastkonfiguration in Reaktion auf ein Neuanliegen des Abtastfreigabesignals während einer zweiten Abtastphase (22), um so die Ausgangssignale der Abtastschaltungselemente (3) der ausgewählten Abtastdomäne zu mindestens einem Abtastdatensignalausgang (10) in Reaktion darauf, dass die Taktimpulse den Abtastschaltungselementen (3) während der zweiten Abtastphase (22) zugeführt werden, zu verschieben, und Vergleichen der tatsächlichen Ausgangssignale aus dem Abtastdatensignalausgang (10) mit den erwarteten Abtastausgangssignalen, **dadurch gekennzeichnet, dass** die Abtastschaltungselemente (3) von einer Gruppe in der ausgewählten Abtastdomäne mit anderen Schaltungselementen entsprechend der Abtastkonfiguration in Reaktion auf das Abtastmodussignal mindestens während der Erfassungsphase (18 bis 21) verbunden werden, um dadurch die von der Abtastkonfiguration während der Erfassungsphase (18 bis 21) empfangenen Signale zu verarbeiten.

2. Verfahren gemäß Anspruch 1, **dadurch gekennzeichnet, dass** das Abtastmodussignal an den Abtastfreigabeeingängen (SEN) der Abtastschaltungselemente (3) der Gruppe mindestens während der Erfassungsphase anliegt.

3. Verfahren gemäß einem beliebigen der vorhergehenden Ansprüche, bei dem für eine Mehrzahl der Abtastschaltungselemente (3) die Abtastauswahlsignale (Abtast-immer-frei) anliegen oder nicht, um zwischen dem Abtastfreigabesignal und dem Abtastmodussignal auszuwählen, um selektive Abtastsignale (Abtast-immer) zu erzeugen, die den Abtastfreigabeeingängen (SEN) der Mehrzahl von Abtastschaltungselementen (3) mindestens während der Erfassungsphase (18 bis 21) zugeführt werden, um so auszuwählen, ob die Abtastschaltungselemente (3) der Mehrzahl von Abtastschaltungselementen in die Gruppe und die von der Abtastkonfiguration empfangenen Prozesssignale eingefügt werden oder ob sie von der Gruppe und den von der funktionalen Konfiguration während der Erfassungsphase (18 bis 21) empfangenen Prozesssignalen ausgeschlossen werden.

4. Integrierte Schaltung, die alle in Anspruch 1 dargelegten Komponenten umfasst und durch ein Verfahren gemäß Anspruch 2 geprüft wird, bei der mindestens eine Mehrzahl von Abtastfreigabeeingängen (SEN) der Abtastschaltungselemente (3) der Gruppe verbunden ist, um das Abtastmodussignal zu empfangen.

5. Integrierte Schaltung, die alle in Anspruch 1 dargelegten Komponenten umfasst und durch ein Verfahren gemäß Anspruch 3 geprüft wird, die eine Mehrzahl von Auswahlschaltungselementen (25) mit Abtastauswahleingängen umfasst, an denen Abtastauswahlsignale (Abtast-Immer-Frei) anliegen können, um zwischen dem Abtastfreigabesignal und dem Abtastmodussignal auszuwählen, um die selektiven Abtastsignale (Abtast-Immer) zu erzeugen, wobei die Auswahlschaltungselemente (25) verbunden sind, um das ausgewählte Signal mehr als einem der Abtastschaltungselemente zuzuführen.

## Revendications

1. Procédé de test d'un circuit intégré comprenant des éléments de circuit logiques (2, 13) et des éléments de circuit de balayage (3), des interconnexions fonctionnelles (4) pour connecter lesdits éléments de circuit (2, 3, 13) dans une configuration fonctionnelle pour le traitement de signaux d'entrée de données, au moins une entrée de signaux Données de Balayage (8), et des interconnexions de balayage (9) pour connecter sélectivement lesdits éléments de circuit de balayage (3) à ladite entrée Données de Balayage (8), dans une pluralité de domaines de balayage se trouvant dans des configurations de balayage respectives, le procédé comprenant les opérations qui consistent à appliquer de manière sélective un signal Mode Balayage auxdits éléments de circuit de balayage (3) pour sélectionner l'un desdits domaines de balayage ; interconnecter les éléments de circuit de balayage (3) dudit domaine de balayage sélectionné se trouvant dans ladite configuration de balayage, en réponse à un signal Validation Balayage affirmé sur les entrées Validation Balayage (SEN) des éléments de circuit de balayage (3) d'au moins le domaine de balayage sélectionné pendant une première phase de balayage (17) ; appliquer des signaux Données de Balayage à ladite entrée Données de Balayage (8) de telle sorte que lesdits signaux Données de Balayage soient décalés d'une manière séquentielle à travers les éléments de circuit de balayage interconnectés (3) du domaine correspondant, et mis en registre par ceux-ci, en réponse à des impulsions d'horloge appliquées au moins auxdits éléments de circuit de balayage (3) pendant ladite première phase de balayage (17) ; interconnecter au moins les éléments de circuit (2, 3, 13) dudit domaine de balayage sélectionné se trouvant dans ladite configuration fonctionnelle, pendant une phase de capture (18 à 21), en réponse à la désaffirmation dudit signal Validation Balayage, de telle sorte que ladite configuration fonctionnelle dudit domaine de balayage sélectionné traite les signaux d'entrée de données et les signaux mis en registre par lesdits éléments de circuit de balayage (3), en réponse à des impulsions d'horloge appliquées auxdits éléments de circuit pendant ladite phase de capture (18 à 21) ; interconnecter de nouveau les éléments de circuit de balayage (3) dudit domaine de balayage sélectionné se trouvant dans ladite configuration de balayage, en réponse à la réaffirmation dudit signal Validation Balayage pendant une deuxième phase de balayage (22), de façon à décaler les signaux de sortie desdits éléments de circuit de balayage (3) dudit domaine de balayage sélectionné vers au moins une sortie de signaux Données de Balayage (10), en réponse auxdites impulsions d'horloge appliquées auxdits éléments de circuit de balayage (3) pendant ladite deuxième phase de balayage (22) ; et comparer les signaux de sortie réels provenant de ladite sortie Données de Balayage (10) aux signaux de sortie de balayage espérés,
**caractérisé en ce que** les éléments de circuit de balayage (3) d'un groupe situé à l'intérieur dudit domaine de balayage sélectionné sont connectés à d'autres éléments de circuit selon ladite configuration de balayage, en réponse audit signal Mode Balayage, au moins pendant ladite phase de capture (18 à 21), de façon à traiter les signaux reçus en provenance de ladite configuration de balayage pendant ladite phase de capture (18 à 21).

2. Procédé selon la revendication 1, **caractérisé en ce que** ledit signal Mode Balayage est affirmé sur lesdites entrées Validation Balayage (SEN) des éléments de circuit de balayage (3) dudit groupe, au moins pendant ladite phase de capture.

3. Procédé selon l'une quelconque des revendications précédentes, dans lequel, pour une pluralité desdits éléments de circuit de balayage (3), des signaux Sélection de Balayage (scan_always_en) sont affirmés ou non pour choisir entre ledit signal Validation Balayage et ledit signal Mode Balayage, pour produire des signaux Balayage Sélectif (scan_always), qui sont appliqués auxdites entrées Validation Balayage (SEN) de ladite pluralité d'éléments de circuit de balayage (3), au moins pendant ladite phase de capture (18 à 21), de façon à choisir si les éléments de circuit de balayage (3) de ladite pluralité d'éléments de circuit de balayage sont inclus dans ledit groupe et traitent les signaux reçus en provenance de ladite configuration de balayage, ou s'ils sont exclus dudit groupe et traitent les signaux reçus en provenance de ladite configuration fonctionnelle pendant ladite phase de capture (18 à 21).

4. Circuit intégré comprenant la totalité des composants mentionnés dans la revendication 1, et testé par un procédé selon la revendication 2, dans lequel au moins une pluralité desdites entrées Validation Balayage (SEN) des éléments de circuit de balayage (3) dudit groupe sont connectés de façon à recevoir ledit signal Mode Balayage.

5. Circuit intégré comprenant la totalité des composants mentionnés dans la revendication 1, et testé par un procédé selon la revendication 3, comprenant une pluralité d'éléments de circuit de sélection (25) ayant des entrées Sélection de Balayage sur lesquelles des signaux Sélection de Balayage (scan_always_en) peuvent être affirmés pour choisir entre ledit signal Validation Balayage et ledit signal Mode Balayage, pour produire lesdits signaux Balayage Sélectif (scan_always), lesdits éléments de circuit de sélection (25) étant connectés de manière à appliquer le signal sélectionné à plus d'un desdits éléments de circuit de balayage.
